# EUROPEAN PATENT APPLICATION

(11) **EP 4 398 035 A1**
(43) Date of publication of application: **10.07.2024**
(21) Application number: 22864676.6
(22) Date of filing: 01.09.2022
(51) Int. Cl.: G03F 7/027, G03F 7/038, G03F 7/20, G03F 7/38, G03F 7/40, H01L 21/312

(54) **WAFER EDGE PROTECTIVE-FILM-FORMING COMPOSITION FOR SEMICONDUCTOR MANUFACTURING**

(30) Priority: 02.09.2021 JP 2021143451
(71) Applicant: Nissan Chemical Corporation, Tokyo 103-6119 (JP)
(72) Inventor: HATTORI, Hayato, Toyama-shi, Toyama 939-2792 (JP); TAKEDA, Satoshi, Toyama-shi, Toyama 939-2792 (JP); MORIYA, Shunsuke, Toyama-shi, Toyama 939-2792 (JP); KISHIOKA, Takahiro, Toyama-shi, Toyama 939-2792 (JP); SAKAMOTO, Rikimaru, Toyama-shi, Toyama 939-2792 (JP)
(74) Representative: Müller-Boré & Partner Patentanwälte PartG mbB
(86) International application number: PCT/JP2022/032897
(87) International publication number: WO 2023/033094

(57) **Abstract**

Provided are a protective film that can completely cover the edge of a substrate (wafer) for semiconductor manufacturing via a simple coating method in the manufacture of a semiconductor device, a protective film-forming composition for forming the protective film, a wafer for semiconductor manufacturing that is manufactured using the protective film, and a method for manufacturing the wafer for semiconductor manufacturing and a semiconductor device. Also provided is a wafer edge protective film-forming composition for semiconductor manufacturing, the composition containing a solvent and a polymer or compound having a crosslinkable group. Preferably, the composition has a viscosity of 100 cps or less at 25°C and is photosensitive. Preferably, the crosslinkable group is selected from the group consisting of an epoxy group, a (meth)acrylic group, a vinyl group, a carboxylic acid group, a thiol group, a silanol group, a cinnamoyl group, and a hydroxyl group.

## Description

### Technical Field

The present invention relates to a film for protecting a substrate (wafer) edge face in the manufacture of a semiconductor, a protective film-forming composition for forming the protective film, a wafer for the manufacture of a semiconductor produced using the protective film, and methods for producing the wafer for the manufacture of a semiconductor and semiconductor device in a semiconductor device manufacturing process.

### Background Art

In manufacturing a semiconductor device, a method for applying a chemical solution containing a metal to a wafer has been studied for the purpose of, for example, improving an etching selection ratio with increasing complication of a manufacturing process. Moreover, for example, in order to impart an increased resolution of a resist pattern in a case of performing exposure using extreme ultraviolet (EUV) and to exhibit a high etching resistance, it has been studied to form a resist film using a resist containing an inorganic metal. Adhesion of the metal to a non-targeted portion of the wafer in the manufacturing process of the semiconductor device adversely affects the electrical properties of the semiconductor device. However, in forming a coating film containing a metal as mentioned above, the chemical solution supplied to a front surface of the wafer flows around to a peripheral edge of the front surface and a peripheral edge of the back surface of the wafer, and the coating film is formed even to a non-targeted peripheral edge of the front surface and back surface peripheral edge, such that there is a concern that these portions are metal-contaminated. Then, when the contaminated portion of the wafer comes into contact with a processing device of the wafer such as an exposure device or an etching device or with a conveyance mechanism of the wafer, wafers conveyed and processed following the wafer through the processing device or conveyance mechanism may also be metal-contaminated, that is, cross-contamination may occur.

In forming a coating film on a front surface of a substrate, a technique, which enables forming the coating film so as not to bring a peripheral edge of the front surface, which is a peripheral edge of the substrate, and a back surface peripheral edge contact with the coating film is disclosed (Patent Literature 1).

A method for manufacturing a semiconductor device, which suppresses release of a film from a bevel portion of a substrate is disclosed (Patent Literature 2).

### Citation List

### Patent Literature

Patent Literature 1: JP 2017-098333 A
Patent Literature 2: JP 2011-228340 A

### Summary of Invention

### Technical Problem

An object of the present invention is to provide a protective film capable of completely covering an edge of a substrate (wafer) for manufacturing a semiconductor by a simple method by application, a protective film-forming composition for forming the protective film, a wafer for manufacturing a semiconductor produced using the protective film, and methods for manufacturing the wafer for manufacturing a semiconductor and a semiconductor device in manufacturing a semiconductor device.

### Solution to Problem

The present invention encompasses the following.
[1] A wafer edge protective film-forming composition for manufacturing a semiconductor, containing a polymer or compound having a crosslinkable group, and a solvent.
[2] The protective film-forming composition according to [1], wherein the crosslinkable group is selected from the group consisting of an epoxy group, a (meth)acrylic group, a vinyl group, a carboxylic acid group, a thiol group, a silanol group, a cinnamoyl group, and a hydroxy group.
[3] The protective film-forming composition according to [1] or [2], which has a viscosity of 100 cps or less at 25°C.
[4] The protective film-forming composition according to any one of [1] to [3], which is photosensitive.
[5] A protective film which is a cured product of a coating film of the protective film-forming composition according to any one of [1] to [4].
[6] The protective film according to [5], which has a thickness of 1 to 10 µm.
[7] The protective film according to [5] or [6], which is for preventing metal contamination of a wafer edge.
[8] The protective film according to any one of [5] to [7], which has been cured by a light having a wavelength of 170 to 800 nm.
[9] A wafer for manufacturing a semiconductor having a protected wafer edge, formed from the protective film-forming composition according to any one of [1] to [4] applied to an edge of a wafer precursor.
[10] A method for manufacturing a semiconductor device, comprising the steps of:
   (A) forming a resist film on a semiconductor substrate;
   (B) forming a resist pattern by irradiation of the resist film with a light or electron beam and subsequent development; and
   (C) processing the semiconductor substrate by etching,
   wherein the method includes a step (X) of forming a protective film of the protective film-forming composition according to any one of [1] to [4] on a front surface edge, and optionally on a bevel portion and/or back surface edge, of a wafer for manufacturing a semiconductor.
[11] The method for manufacturing a semiconductor device according to [10], wherein the method includes the step (X) before the step (A).
[12] The method for manufacturing a semiconductor device according to [10], wherein the method includes the step (X) between the step (A) and the step (B).
[13] The method for manufacturing a semiconductor device according to [10], wherein the method includes the step (X) after the step (B) or after the step (C).
[14] The method for manufacturing a semiconductor device according to any one of [10] to [13], wherein the method includes, after the step (X), a step (Y) of removing the resist film formed on the protective film.
[15] The method for manufacturing a semiconductor device according to any one of [10] to [13], wherein the method includes, after the step (X), a step (Z) of removing the protective film.
[16] The method for manufacturing a semiconductor device according to [14], wherein the method includes, after the step (Y), a step (Z) of removing the protective film.
[17] The method for manufacturing a semiconductor device according to any one of [10] to [16], wherein the resist film contains a metal.
[18] The method for manufacturing a semiconductor device according to any one of [10] to [17], the step (X) includes applying the protective film-forming composition according to [4] followed by exposure and development thereof on a predetermined region.
[19] The method for manufacturing a semiconductor device according to [15] or [16], wherein the step (Z) is performed by ashing, or a treatment with hydrofluoric acid, an organic solvent, an alkaline developer or a semiconductor cleaning solution.
[20] A method for manufacturing a wafer for manufacturing a semiconductor, comprising the step of applying the protective film-forming composition according to any one of [1] to [4] to an edge of a wafer precursor to produce a wafer having a protected edge.

### Advantageous Effects of Invention

In manufacturing a semiconductor device, it is possible to prevent cross contamination due to metal contamination in a subsequent semiconductor device manufacturing processes using a protective film capable of completely covering the edge of a substrate (wafer) for manufacturing a semiconductor by a simple method by application, and it is possible to improve a yield of a high-quality semiconductor manufacturing device.

### Description of Embodiments

A method for manufacturing a semiconductor device according to the present invention comprises the steps of:
(A) forming a resist film on a semiconductor substrate;
(B) forming a resist pattern by irradiation of the resist film with a light or electron beam and subsequent development; and
(C) processing the semiconductor substrate by etching or processing the semiconductor substrate by etching through the patterned resist,
wherein the method includes a step (X) of forming a protective film of a wafer edge protective film-forming composition for manufacturing a semiconductor on a front surface edge, and optionally on a bevel portion and/or back surface edge, of a wafer for manufacturing a semiconductor, the wafer edge protective film-forming composition containing a polymer or compound having a crosslinkable group, and a solvent.

Hereinafter, the method will be described in order.

### [Step (A) of forming resist film on semiconductor substrate]

A resist film is formed on a semiconductor substrate. The semiconductor substrate is a wafer used for manufacturing a semiconductor element or the like, and in addition to a generally used silicon wafer and germanium wafer, for example, a compound semiconductor wafer formed by bonding two or more elements such as gallium arsenide, indium phosphide, gallium nitride, indium nitride, and aluminum nitride may be used. The semiconductor substrate usually has a disk shape, and a size thereof is, for example, 4, 6, 8, or 12 inches, or the like. A commercially available product may be used.

In a case where a semiconductor substrate having a front surface on which an inorganic film is formed is used, the inorganic film is formed by, for example, an atomic layer deposition (ALD) method, a chemical vapor deposition (CVD) method, a reactive sputtering method, an ion-plating method, a vacuum deposition method, or a spin coating method (spin on glass: SOG). Examples of the inorganic film include a polysilicon film, a silicon oxide film, a silicon nitride film, a Boro-Phospho Silicate Glass (BPSG) film, a titanium nitride film, a titanium nitride oxide film, a tungsten film, a gallium nitride film, and a gallium arsenide film.

On such a semiconductor substrate, a resist underlayer film, a resist film, and the like having predetermined thicknesses are formed by an appropriate application method such as a spray, a spinner, or a coater. In general, in a case of a rotary coating method, each of the resist underlayer film forming composition, the resist film-forming composition, and the like is supplied from above the central portion of the rotating disk-shaped substrate through a nozzle or the like. Usually, these films are baked using a heating means such as a hot plate.

A photoresist used for forming a resist film is not particularly limited as long as it is sensitive to the light used for exposure. Either a negative photoresist or a positive photoresist may be used. Examples of the photoresist include a positive photoresist formed of a novolac resin and 1,2-naphthoquinone diazide sulfonic acid ester; a chemically amplified photoresist formed of a binder having a group degradable by an acid to increase an alkali dissolution rate and a photoacid generator; a chemically amplified photoresist formed of a low-molecular-weight compound degradable by an acid to increase an alkali dissolution rate of the photoresist, an alkali-soluble binder, and a photoacid generator; a chemically amplified photoresist formed of a binder having a group degradable by an acid to increase an alkali dissolution rate, a low-molecular-weight compound degradable by an acid to increase an alkali dissolution rate of the photoresist, and a photoacid generator; and a resist containing metal elements. Examples thereof include V146G (trade name) manufactured by JSR Corporation, APEX-E (trade name) manufactured by Shipley Company L.L.C, PAR710 (trade name) manufactured by Sumitomo Chemical Co., Ltd., and AR2772 and SEPR430 (trade name) manufactured by Shin-Etsu Chemical Co., Ltd. In addition, examples thereof include a fluorine-containing atomic polymer-based photoresist as described in Proc. SPIE, Vol. 3999, 330-334 (2000), Proc. SPIE, Vol. 3999, 357-364 (2000), and Proc. SPIE, Vol. 3999, 365-374 (2000). A negative photoresist is preferable.

The resist film-forming composition used for forming the resist film may contain one or more metals. Examples of the form of the metal include a metal salt, a metal complex, and other metal-containing compounds in addition to a simple metal. The metal species is not particularly limited, and examples thereof include tin, indium, antimony, bismuth, gallium, germanium, aluminum, zirconium, hafnium, cerium, lanthanum, and cesium.

The conditions for baking the resist film are appropriately selected from a bake temperature of 70°C to 400°C and a bake time of 0.3 minutes to 60 minutes. Preferably, the bake temperature is 80°C to 350°C and the bake time is 0.5 minutes to 30 minutes, and more preferably, the bake temperature is 90°C to 300°C and the bake time is 0.8 minutes to 10 minutes.

A lower limit of an average thickness of the resist film is preferably 1 nm and more preferably 3 nm, 5 nm, or 10 nm. An upper limit of the average thickness of the resist film is 5,000 nm, 3,000 nm, or 2,000 nm, preferably 1,000 nm, more preferably 200 nm, and more preferably 50 nm.

### [Step (X) of forming protective film]

The step (X) of forming the protective film of the protective film-forming composition on the front surface edge, and optionally on the bevel portion and/or back surface edge, of the wafer for manufacturing a semiconductor is performed at an appropriate time point. In the step (X), preferably, the protective film-forming composition is applied, and exposure and development are performed on a predetermined region. The step (X) may be performed before the step (A), may be performed between the step (A) and the step (B), or may be performed after the step (B) or after the step (C).

Note that, in the present specification, a surface of a substrate on which a device portion such as a resist film is provided is referred to as a front surface, and a surface on the opposite side is referred to as a back surface. In addition, the front surface edge refers to a region having a width of usually 1 to 10 mm between an edge of the device portion provided on the substrate and the bevel portion, the bevel portion refers to a curved region connecting the front surface edge and the back surface edge, and the back surface edge refers to a region of the back surface of the substrate opposite to the front surface edge.

First, a protective film-forming composition (described later again) is applied to a semiconductor substrate on which a resist film and the like are formed. A method for applying the protective film-forming composition is not particularly limited, and for example, a known means such as a rotary coating method (spin coating method) or a spraying method may be adopted. For example, when a rotary coating method is adopted, the protective film-forming composition is supplied through a nozzle from above or near the front surface edge of a rotating disk-shaped substrate while rotating the semiconductor substrate having a resist film and the like formed thereon at a predetermined rotation speed. Preferably, it is also supplied to the bevel portion and/or back surface edge of the substrate from the vicinity of each of the bevel portion and the back surface edge through a nozzle.

The conditions for the rotary coating may be appropriately selected, and are not limited at all, but typical conditions are as follows.
· Viscosity of protective film-forming composition: about 100 cps or less
· Rotation speed of wafer:
   · · At time of supplying protective film-forming composition: 50 to 500 rpm
   · · At time of shaking off for drying: 700 to 2,000 rpm
   · Thickness of protective film: 300 nm

Next, the protective film-forming composition is exposed. The exposure may be performed by irradiating the protective film-forming composition with an active ray (an i-ray, a KrF excimer laser, an ArF excimer laser, extreme ultraviolet (EUV), or an electron beam (EB)) such as an ultraviolet ray, a visible ray, or a radiation through a mask or without a mask. Note that soft bake (SB) may be performed before the exposure, or post-exposure bake (PEB) may be performed after the exposure and before the development. A post-exposure bake temperature is preferably 50°C to 150°C, and a post-exposure bake time is preferably 1 minute to 10 minutes.

Next, the exposed protective film-forming composition is developed. The development may be performed by removing an exposed portion of the protective film-forming composition after the exposure with a developer, and a development temperature and a development time are appropriately selected from 5°C to 50°C and 10 seconds to 300 seconds, respectively.

Examples of an organic solvent contained in the developer include an alcohol-based solvent, an ether-based solvent, a ketone-based solvent, an amide-based solvent, an ester-based solvent, and a hydrocarbon-based solvent. As the organic solvent in the developer, an ester-based solvent, a ketone-based solvent, or a combination thereof is preferably contained. The developer may contain one organic solvent alone or two or more organic solvents.

Examples of the alcohol-based solvent include an aliphatic monoalcohol-based solvent having 1 to 18 carbon atoms such as 4-methyl-2-pentanol or n-hexanol; an alicyclic monoalcohol-based solvent having 3 to 18 carbon atoms such as cyclohexanol; and a polyhydric alcohol partial ether-based solvent having 3 to 19 carbon atoms such as propylene glycol monomethyl ether.

Examples of the ether-based solvent include a dialkyl ether-based solvent such as diethyl ether, dipropyl ether, dibutyl ether, dipentyl ether, diisoamyl ether, dihexyl ether, or diheptyl ether; a cyclic ether-based solvent such as tetrahydrofuran or tetrahydropyran; and an aromatic ring-containing ether-based solvent such as diphenyl ether or anisole.

Examples of the ketone-based solvent include a chain ketone-based solvent such as acetone, methyl ethyl ketone, methyl-n-propyl ketone, methyl-n-butyl ketone, diethyl ketone, methyl-iso-butyl ketone, 2-heptanone, ethyl-n-butyl ketone, methyl-n-hexyl ketone, di-iso-butyl ketone, or trimethylnonanone; a cyclic ketone-based solvent such as cyclopentanone, cyclohexanone, cycloheptanone, cyclooctanone, or methylcyclohexanone; and 2,4-pentanedione, acetonylacetone, and acetophenone.

Examples of the amide-based solvent include a cyclic amide-based solvent such as N,N'-dimethylimidazolidinone or N-methylpyrrolidone; and a chain amide-based solvent such as N-methylformamide, N,N-dimethylformamide, N,N-diethylformamide, acetamide, N-methylacetamide, N,N-dimethylacetamide, or N-methylpropionamide.

Examples of the ester-based solvent include a monocarboxylic acid ester-based solvent such as n-butyl acetate or ethyl lactate; a polyhydric alcohol carboxylate-based solvent such as propylene glycol acetate; a polyhydric alcohol partial ether carboxylate-based solvent such as propylene glycol monomethyl ether acetate; a polyhydric carboxylic acid diester-based solvent such as diethyl oxalate; and a carbonate-based solvent such as dimethyl carbonate or diethyl carbonate.

Examples of the hydrocarbon-based solvent include an aliphatic hydrocarbon-based solvent having 5 to 12 carbon atoms such as n-pentane or n-hexane; and an aromatic hydrocarbon-based solvent having 6 to 16 carbon atoms such as toluene or xylene.

Of these, an ester-based solvent, a ketone-based solvent, an ether-based solvent, and a combination thereof are preferable, and an ester-based solvent, a ketone-based solvent, and a combination thereof are more preferable. As the ester-based solvent, propylene glycol monomethyl ether acetate is preferable. As the ketone-based solvent, cyclohexanone is preferable. As the ether-based solvent, propylene glycol monomethyl ether is preferable.

The lower limit of the content of the organic solvent in the developer is preferably 80% by mass, more preferably 90% by mass, still more preferably 99% by mass, and particularly preferably 100% by mass. When the content of the organic solvent in the developer is within the above range, a dissolution contrast between the exposed portion and the unexposed portion can be improved, and as a result, a resist pattern having a better lithography performance can be formed. Examples of components other than the organic solvent include water and silicone oil.

The developer may contain a nitrogen-containing compound. When the developer contains the nitrogen-containing compound, film loss in the formed resist pattern may further be reduced.

As the developer, a developer of an aqueous solution may be used instead of the organic solvent-based developer. Specifically, the developer may be an aqueous alkali solution such as sodium hydroxide, potassium hydroxide, sodium silicate, ammonia, monoethylamine, diethylamine, triethylamine, triethanolamine, or tetramethylammonium hydroxide. A base concentration of these aqueous solutions is not particularly limited, and may be, for example, within the range of 0.1 to 10% by weight.

In addition, alcohols or a surfactant may be added to the developer. Each of the alcohols or surfactant may be blended within the range of preferably 0.01 to 10 parts by weight and more preferably 0.1 to 5 parts by weight with respect to 100 parts by weight of the developer. Examples of the surfactant include an ionic or nonionic fluorine-based surfactant and a silicone-based surfactant.

Examples of the developing method include a method in which a substrate is immersed in a tank filled with a developer for a certain period of time (dipping method), a method in which a developer is raised on a surface of a substrate by surface tension and is stopped for a certain period of time (paddle method), a method in which a developer is sprayed onto a surface of a substrate (spraying method), and a method in which a developer is continuously applied onto a substrate rotating at a certain speed while a developer application nozzle is scanned at a certain speed (dynamic dispensing method).

Next, the developed protective film-forming composition is baked. A desired pattern may be formed by baking the pattern obtained after development. A heating temperature in the heat treatment is usually 150°C or higher and 350°C or lower, and preferably within the range of 200 to 300°C. A heat treatment time is a time until the protective film-forming composition is cured, and is preferably about shorter than 30 minutes in consideration of productivity.

The lower limit of average thickness of the protective film is preferably 1 nm and more preferably 3 nm. The upper limit of the average thickness of the protective film is, for example, 10 µm, 8 µm, 5 µm, 3 µm, 1 µm, 800 nm, 500 nm, or 300 nm.

After the step (X), in a step (Y), the resist film formed on the protective film may be removed with a removing solution. In this case, as in the step (X), it is preferable to apply the removing solution to the front surface edge, and optionally the bevel portion and/or back surface edge, of the wafer for manufacturing a semiconductor. Examples of the resist removing solution include a mixed solution of propylene glycol monomethyl ether, propylene glycol monomethyl ether acetate, cyclohexanone, water, butyl acetate, a tetramethylammonium aqueous solution, or a combination thereof. Of these, propylene glycol monomethyl ether acetate and water are preferable from the viewpoint of removability of the resist film.

After the step (X) or the step (Y), in a step (Z), the protective film may be removed by ashing, or a treatment with hydrofluoric acid, an organic solvent, an alkaline developer or a semiconductor cleaning solution. Thereafter, cleaning is preferably performed with an appropriate solvent, a conventional semiconductor cleaning solution, or the like.

The steps (X), (Y), and (Z) may be performed simultaneously with the steps (A), (B), and (C), or at any time before and after each step. For example, in a case where the step (X) is included before the step (A), the step (Y) of removing the resist film formed on the protective film may be performed between the step (A) and the step (B); and the step (Z) of removing the protective film may be performed between the step (Y) and the step (B). In addition, in a case where the step (X) is included between the step (A) and either the step (B) or the step (C), the step (Z) of removing the protective film may be performed between the step (X) and either the step (B) or the step (C).

### [Step (B) of forming resist pattern by irradiation of resist film with light or electron beam and subsequent development and step (C) of processing semiconductor substrate by etching]

The exposure of the resist film is performed through a mask (reticle) for forming a predetermined pattern, and for example, an i-ray, a KrF energy laser, an ArF energy laser, extreme ultraviolet (EUV), or an electron beam (EB) is used. Note that soft bake (SB) may be performed before the exposure, or post-exposure bake (PEB) may be performed after the exposure and before the development. The post-exposure bake temperature is preferably 50°C to 150°C, and the post-exposure bake time is preferably 1 minute to 10 minutes.

In the development, an alkaline developer is used, and a development temperature and a development time are appropriately selected from 5°C to 50°C and 10 seconds to 300 seconds, respectively. As the alkaline developer, for example, aqueous solutions of alkalis, for example, inorganic alkalis such as sodium hydroxide, potassium hydroxide, sodium carbonate, sodium silicate, sodium metasilicate, and ammonia water, primary amines such as ethylamine and n-propylamine, secondary amines such as diethylamine and di-n-butyl amine, tertiary amines such as triethylamine and methyldiethylamine, alcoholamines such as dimethylethanolamine and triethanolamine, quaternary ammonium salts such as tetramethylammonium hydroxide, tetraethylammonium hydroxide, and choline, and cyclic amines such as pyrrole and piperidine, can be used. The base concentration of these aqueous solutions is not particularly limited, and may be, for example, 0.1 to 10% by weight.

Moreover, an appropriate amount of alcohols such as isopropyl alcohol and a surfactant such as a nonionic surfactant may be added to the aqueous solution of alkalis. Each of these alcohols may be blended within the range of preferably 0.01 to 10 parts by weight and more preferably 0.1 to 5 parts by weight with respect to 100 parts by weight of the developer. Of these, a preferred developer is a quaternary ammonium salt and more preferably tetramethylammonium hydroxide and choline. Furthermore, a surfactant or the like may be added to the developer.

A method of performing development using an organic solvent such as a polyhydric alcohol-based solvent having 2 to 18 carbon atoms such as 1,2-propylene glycol or butyl acetate instead of the alkaline developer, so as to develop a portion where an alkali dissolution rate of the photoresist is not increased, may also be used.

The semiconductor substrate subjected to the exposure and development is baked. The means for baking is not particularly limited, and for example, a proximity bake furnace for securing a gap using more than one substrate support pin between a substrate and a hot plate is suitably used.

The bake temperature is usually within the range of 40°C to 300°C and preferably 200 to 300°C for 1 to 30 minutes, and may be set to 90°C or lower in a case where it is required to avoid damage to the resist pattern.

The baking may be performed on the semiconductor substrate before the post-exposure development. The means and conditions of the baking are as mentioned above, and may be set to 90°C or lower when it is required to avoid damage to the resist pattern.

Next, the resist underlayer film is etched and preferably dry-etched using the formed resist pattern as a mask, to form a patterned resist. At this time, in a case where an inorganic film is formed on the surface of the semiconductor substrate used, the surface of the inorganic film is exposed; and in a case where no inorganic film is formed on the surface of the semiconductor substrate used, the surface of the semiconductor substrate is exposed. Thereafter, the semiconductor substrate is processed using the patterned resist by a method known per se (dry etching method or the like).

The etching for processing the semiconductor substrate may be a known method. For example, in a case where the semiconductor substrate is a silicon substrate, the etching also includes, in addition to a step of performing shape processing by dry etching using a fluorine-based gas such as carbon tetrafluoride, a surface treatment step such as removing a silicon nitride film present on a surface of the semiconductor substrate with thermal phosphoric acid.

A semiconductor device may be manufactured through the above steps.

### <Method for manufacturing wafer for manufacturing semiconductor>

A method for manufacturing a wafer for manufacturing a semiconductor according to the present invention includes, in the method for manufacturing a semiconductor device as described above, a step of applying a wafer edge protective film-forming composition for manufacturing a semiconductor, which contains a solvent and a polymer or compound having a crosslinkable group, to a front surface edge, and optionally a bevel portion and/or back surface edge, of a wafer precursor for manufacturing a semiconductor to produce a wafer for manufacturing semiconductor with a protective film.

The wafer precursor for manufacturing a semiconductor refers to a precursor obtained by subjecting a semiconductor substrate to at least one step of the method for manufacturing a semiconductor device. For example, it refers to a material from the steps of forming an inorganic film, a resist underlayer film, a resist film, and the like on a semiconductor substrate in the method for manufacturing a semiconductor device as described above, and not yet to be used for the step of forming a resist pattern by irradiation of the resist film with a light or electron beam and subsequent development.

### (Method for manufacturing wafer for manufacturing semiconductor)

The wafer edge protective film-forming composition for manufacturing a semiconductor, which contains a solvent and a polymer or compound having a crosslinkable group, is applied, by spin coating, to a front surface edge, and optionally a bevel portion and/or back surface edge, of a wafer precursor for manufacturing a semiconductor obtained by one or more steps of the semiconductor device manufacturing process.

Thereafter, the semiconductor substrate may be baked. In this case, the means for baking is not particularly limited, and for example, a proximity bake furnace for securing a gap using more than one substrate support pin between a substrate and a hot plate is suitably used. A bake temperature is usually within the range of 40°C to 300°C and preferably 200 to 300°C for 1 to 30 minutes.

After the protective film-forming composition is applied, the protective film edge face may be subjected to a known treatment in the semiconductor manufacturing process such as edge bead removal or backrinsing.

### <Wafer for manufacturing semiconductor>

The wafer for manufacturing a semiconductor of the present invention is a wafer for manufacturing a semiconductor having a protected wafer edge formed by applying the protective film-forming composition containing a solvent and a polymer having a crosslinkable group to a wafer edge.

### <Protective film-forming composition>

The protective film-forming composition of the present invention is a protective film-forming composition used for protecting a wafer front surface edge for manufacturing a semiconductor, the protective film-forming composition containing a solvent and a polymer or compound having a crosslinkable group.

The crosslinkable group means a group capable of forming a crosslinked structure by an action of a light, an electron beam, other electromagnetic waves, a radical, an acid, heat, water, oxygen, or the like. Examples thereof include, but are not limited to, an epoxy group, an acrylic group, a vinyl group, a carboxylic acid group, a thiol group, a silanol group, a cinnamoyl group, and a hydroxy group (also including a phenolic hydroxy group).

Examples of the polymer or compound having a crosslinkable group include, but are not limited to, the following:
· epoxy (meth)acrylate;
· cinnamic acid-grafted epoxy novolac;
· phenoplast, which is a thermosetting material obtained by polycondensation of phenols and aldehydes with removal of water and formation of a three-dimensional network;
for example, a melamine resin such as trimethylolmelamine or hexamethylolmelamine, a urea-based resin such as dimethylolpropylene urea, dimethylolethylene urea, or dimethylolhydroxyne urea, or an amino blast resin such as a dimethyloluron resin;
· (block) isocyanate;
· vinyl ether;
· a polysiloxane resin having a (meth)acrylic group; and
· an epoxy resin.

Examples of the solvent contained in the protective film-forming composition of the present invention include water, ethylene glycol monomethyl ether, ethylene glycol monoethyl ether, methyl cellosolve acetate, ethyl cellosolve acetate, diethylene glycol monomethyl ether, diethylene glycol monoethyl ether, propylene glycol, propylene glycol monomethyl ether, propylene glycol monoethyl ether, propylene glycol monomethyl ether acetate, propylene glycol propyl ether acetate, toluene, xylene, methyl ethyl ketone, methyl isobutyl ketone, cyclopentanone, cyclohexanone, cycloheptanone, 4-methyl-2-pentanol, methyl 2-hydroxyisobutyrate, ethyl 2-hydroxyisobutyrate, ethyl ethoxyacetate, 2-hydroxyethyl acetate, methyl 3-methoxypropionate, ethyl 3-methoxypropionate, ethyl 3-ethoxypropionate, methyl 3-ethoxypropionate, methyl pyruvate, ethyl pyruvate, ethyl acetate, butyl acetate, ethyl lactate, butyl lactate, 2-heptanone, methoxycyclopentane, anisole, γ-butyrolactone, N-methylpyrrolidone, N,N-dimethylformamide, and N,N-dimethylacetamide. These solvents can be used each alone or in combination of two or more thereof.

The solvent may be added so that the protective film-forming composition of the present invention has an appropriate viscosity. In general, a preferred proportion is within the range of about 100 to 3,000 parts by mass of the solvent per 100 parts by mass of the polymer or compound having a crosslinkable group.

Furthermore, the protective film-forming composition of the present invention may contain, as necessary, a radical polymerization initiator (photopolymerization initiator or the like), an acid (catalyst), a thermal acid generator, a photoacid generator, a base (catalyst), a thermal base generator, a photobase generator, an antioxidant, a polymerization inhibitor, a crosslinking agent (polyfunctional acrylic or the like), an adhesion improver, an adhesion aid (silane coupling agent), a surfactant, an antifoaming agent, a rheology modifier, a pigment, a dye, a storage stabilizer, a dissolution accelerator such as a polyhydric phenol or a polyhydric carboxylic acid, a sensitizer, and the like.

The radical polymerization initiator may be any initiator as long as it can release a substance that initiates radical polymerization by light irradiation and/or heating. Examples of a photoradical polymerization initiator include a benzophenone derivative, an imidazole derivative, a bisimidazole derivative, an N-arylglycine derivative, an organic azide compound, a titanocene compound, an aluminate complex, an organic peroxide, an N-alkylpyridinium salt, and a thioxanthone derivative. More specifically, examples thereof include, but are not limited to, benzophenone, 1,3-di(tert-butyldioxycarbonyl)benzophenone, 3,3',4,4'-tetrakis(tert-butyldioxycarbonyl)benzophenone, 3-phenyl-5-isoxazolone, 2-mercaptobenzimidazole, bis(2,4,5-triphenyl)imidazole, 2,2-dimethoxy-1,2-diphenylethan-1-one, 1-hydroxycyclohexylphenyl ketone, 2-benzyl-2-dimethylamino-1-(4-morpholinophenyl)-butan-1-one, and bis(η⁵-2,4-cyclopentadien-1-yl)-bis(2,6-difluoro-3-(1H-pyrrol-1-yl)-phenyl)titanium).

As the photoradical polymerization initiator, a commercially available product may also be used, and examples thereof include IRGACURE (registered trademark) 651, 184, 369, and 784 manufactured by BASF SE. In addition, specific examples of the commercially available product include IRGACURE (registered trademark) 500, 907, 379, 819, 127, 500, 754, 250, 1800, 1870, and OXE01, and DAROCUR (registered trademark) TPO and 1173 manufactured by BASF SE; Speedcure (registered trademark) MBB, PBZ, ITX, CTX, and EDB manufactured by Lambson Ltd.; Esacure (registered trademark) ONE, KIP150, and KTO46 manufactured by Lamberti S.p.A.; and KAYACURE (registered trademark) DETX-S, CTX, BMS, and DMBI manufactured by Nippon Kayaku Co., Ltd.

In addition, examples of a thermal radical polymerization initiator include, but are not limited to, a peroxide such as acetyl peroxide, benzoyl peroxide, methyl ethyl ketone peroxide, cyclohexanone peroxide, hydrogen peroxide, tert-butyl hydroperoxide, cumene hydroperoxide, di-tert-butyl peroxide, dicumyl peroxide, dilauroyl peroxide, tert-butyl peroxy acetate, tert-butyl peroxy pivalate, or tert-butyl peroxy-2-ethylhexanoate; an azo compound such as 2,2'-azobisisobutyronitrile, 2,2'-azobis(2,4-dimethylvaleronitrile), (1-phenylethyl)azodiphenylmethane, 2,2'-azobis(4-methoxy-2,4-dimethylvaleronitrile), dimethyl-2,2'-azobisisobutyrate, 2,2'-azobis(2-methylbutyronitrile), 1,1'-azobis(1-cyclohexanecarbonitrile), 2-(carbamoylazo)isobutyronitrile, 2,2'-azobis(2,4,4-trimethylpentane), 2-phenylazo-2,4-dimethyl-4-methoxyvaleronitrile, or 2,2'-azobis(2-methylpropane); and a persulfate such as ammonium persulfate, sodium persulfate, or potassium persulfate.

Examples of the commercially available thermal radical polymerization initiator include, but are not limited to, PERLOYL (registered trademark) IB, NPP, IPP, SBP, TCP, OPP, SA, 355, and L, PERBUTYL (registered trademark) ND, NHP, MA, PV, 355, A, C, D, E, L, I, O, P, and Z, PERHEXYL (registered trademark) ND, PV, D, I, O, and Z, PEROCTA (registered trademark) ND, NYPER (registered trademark) PMB, BMT, and BW, PERTETRA (registered trademark) A, PERHEXA (registered trademark) MC, TMH, HC, 250, 25B, C, 25Z, 22, and V, PEROCTA (registered trademark) O, PERCUMYI, (registered trademark) ND and D, PERMENTA (registered trademark) H, and NOFMER (registered trademark) BC manufactured by NOF CORPORATION; V-70, V-65, V-59, V-40, V-30, VA-044, VA-046B, VA-061, V-50, VA-057, VA-086, VF-096, VAm-110, V-601, and V-501 manufactured by Wako Pure Chemical Industries, Ltd.; IRGACURE (registered trademark) 184, 369, 651, 500, 819, 907, 784, 2959, CGI1700, CGI1750, CGI1850, and CG24-61, DAROCUR (registered trademark) 1116 and 1173, and LUCIRIN (registered trademark) TPO manufactured by BASF SE; UVECRYL (registered trademark) P36 manufactured by Cytec Surface Specialties S.A.; and Esacure (registered trademark) KIP150, KIP65LT, KIP100F, KT37, KT55, KTO46, and KIP75B manufactured by Lamberti S.p.A.

The radical polymerization initiators may be used each alone or in combination of two or more thereof. The content of the radical polymerization initiator is preferably 1 part by mass or more, 2 parts by mass or more, 3 parts by mass or more, 50 parts by mass or less, 20 parts by mass or less, or 10 parts by mass or less, with respect to 100 parts by mass of the polymer or compound having a crosslinkable group.

As the polymerization inhibitor, a hindered phenol compound may be used, and specific examples thereof include 2,6-diisobutylphenol, 3,5-di-t-butylphenol, 3,5-di-t-butylcresol, hydroquinone, hydroquinone monomethyl ether, N-nitroso-N-phenylhydroxyamine aluminum, pyrogallol, t-butylcatechol, 4-methoxy-1-naphthol, 2,6-di-t-butyl-4-methylphenol, 2,5-di-t-butyl-hydroquinone, octadecyl-3-(3,5-di-t-butyl-4-hydroxyphenyl)propionate, isooctyl-3-(3,5-di-t-butyl)-4-hydroxyphenyl)propionate, 4,4'-methylenebis(2,6-di-t-butylphenol), 4,4'-thio-bis(3-methyl-6-t-butylphenol), 4,4'-butylidene-bis(3-methyl-6-t-butylphenol), triethylene glycol-bis[3-(3-t-butyl-5-methyl-4-hydroxyphenyl)propionate], 1,6-hexanediol-bis[3-(3,5-di-t-butyl-4)-hydroxyphenyl)propionate], 2,2-thio-diethylenebis[3-(3,5-di-t-butyl-4-hydroxyphenyl)propionate], N,N'-hexamethylenebis(3,5-di-t-butyl-4-hydroxyhydrocinnamamide), 2,2'-methylene-bis(4-methyl-6-t-butylphenol), 2,2'-methylene-bis(4-ethyl-6-t-butylphenol), pentaerythrityl-tetrakis[3-(3,5-di-t-butyl-4-hydroxyphenyl)propionate], tris-(3,5-di-t-butyl-4-hydroxybenzyl)-isocyanurate, 1,3,5-trimethyl-2,4,6-tris(3,5-di-t-butyl-4 -hydroxybenzyl)benzene, 1,3,5-tris(3-hydroxy-2,6-dimethyl-4-isopropylbenzyl)-1,3,5-triazine-2,4,6-(1H,3H,5H)-trione, 1,3,5-tris(4-t-butyl-3-hydroxy-2,6-dimethylbenzyl)-1,3,5-triazine-2,4,6-(1H,3H,5H)-trione, 1,3,5-tris(4-s-butyl-3-hydroxy-2,6-dimethylbenzyl)-1,3,5-triazine-2,4,6-(1H,3H,5H)-trione, 1,3,5-tris[4-(1-ethylpropyl)-3-hydroxy-2,6-dimethylbenzyl]-1,3,5-triazine-2,4,6-(1H,3H,5H)-trione, 1,3,5-tris[4-triethylmethyl-3-hydroxy-2,6-dimethylbenzyl]-1,3,5-triazine-2,4,6-(1H,3H,SH)-trione, 1,3,5-tris(3-hydroxy-2,6-dimethyl-4-phenylbenzyl)-1,3,5-triazine-2,4,6-(1H,3H,SH)-trione, 1,3,5-tris(4-t-butyl-3-hydroxy-2,5,6-trimethylbenzyl)-1,3,5-triazine-2,4,6-(1H,3H,5H)-trione, 1,3,5-tris(4-t-butyl-5-ethyl-3-hydroxy-2,6-dimethylbenzyl)-1,3,5-triazine-2,4,6-(1H,3H,SH)-trione, 1,3,5-tris(4-t-butyl-6-ethyl-3-hydroxy-2-methylbenzyl)-1,3,5-triazine-2,4,6-(1H,3H,5H)-trione,1,3,5-tris(4-t-butyl-6-ethyl-3-hydroxy-2,5-dimethylbenzyl)-1,3,5-triazine-2,4,6-(1H,3H,5H)-trione, 1,3,5-tris(4-t-butyl-5,6-diethyl-3-hydroxy-2-methylbenzyl)-1,3,5-triazine-2,4,6-(1H,3H,5H)-trione, 1,3,5-tris(4-t-butyl-3-hydroxy-2-methylbenzyl)-1,3,5-triazine-2,4,6-(1H,3H,5H)-trione, 1,3,5-tris(4-t-butyl-3-hydroxy-2,5-dimethylbenzyl)-1,3,5-triazine-2,4,6-(1H,3H,5H)-trione, and 1,3,5-tris(4-t-butyl-5-ethyl-3-hydroxy-2-methylbenzyl)-1,3,5-triazine-2,4,6-(1H,3H,SH)-trione.

Of the hindered phenol compounds, 1,3,5-tris(4-t-butyl-3-hydroxy-2,6-dimethylbenzyl)-1,3,5-triazine-2,4,6-(1H,3H,SH)-trione is preferable.

As the polymerization inhibitor, a commercially available product may be used, and specific examples thereof include Irganox-3114 (manufactured by BASF Japan Ltd.).

The polymerization inhibitors may be used each alone or in combination of two or more thereof. The content of the polymerization inhibitor is preferably within the range of 0.01 to 1 part by mass and more preferably 0.01 to 0.5 parts by mass with respect to 100 parts by mass of the polymer or compound having a crosslinkable group.

Examples of the surfactant include a polyoxyethylene alkyl ether compound such as polyoxyethylene lauryl ether, polyoxyethylene stearyl ether, or polyoxyethylene oleyl ether, a polyoxyethylene alkyl allyl ether compound such as polyoxyethylene octyl phenol ether or polyoxyethylene nonyl phenol ether, a polyoxyethylene-polyoxypropylene block copolymer compound, a sorbitan fatty acid ester compound such as sorbitan monolaurate, sorbitan monopalmitate, sorbitan monostearate, sorbitan trioleate, or sorbitan tristearate, and a polyoxyethylene sorbitan fatty acid ester compound such as polyoxyethylene sorbitan monolaurate, polyoxyethylene sorbitan monopalmitate, polyoxyethylene sorbitan monostearate, or polyoxyethylene sorbitan tristearate. In addition, examples thereof include fluorine-based surfactants such as EFTOP EF301, EF303, and EF352 (trade name) (manufactured by Tochem Products Inc.), MEGAFACE F171, F173, R-08, and R-30 (trade name) (manufactured by DIC Corporation), FLUORAD FC430 and FC431 (manufactured by Sumitomo 3M Ltd.), and AsahiGuard AG710 and SURFLON S-382, SC101, SC102, SC103, SC104, SC105, and SC106 (trade name) (manufactured by AGC Inc.) and Organosiloxane Polymer-KP341 (manufactured by Shin-Etsu Chemical Co., Ltd.).

The surfactants may be used each alone or in combination of two or more thereof. The content of the surfactant is preferably 0.1 parts by mass or more, 0.5 parts by mass or more, 5 parts by mass or less, or 2 parts by mass or less, with respect to 100 parts by mass of the polymer or compound having a crosslinkable group.

As the acid catalyst, an acidic compound, basic compound, or various compounds that generate an acid or base by heat may be used.

As the acidic compound, a sulfonic acid compound or a carboxylic acid compound can be used.

Examples of the sulfonic acid compound or the carboxylic acid compound include p-toluenesulfonic acid, trifluoromethanesulfonic acid, pyridinium trifluoromethanesulfonate (=pyridinium trifluoromethanesulfonic acid), pyridinium-p-toluenesulfonate, pyridinium-4-hydroxybenzene sulfonate, salicylic acid, camphorsulfonic acid, 5-sulfosalicylic acid, 4-chlorobenzenesulfonic acid, 4-phenolsulfonic acid, pyridinium-4-phenolsulfonate, benzenedisulfonic acid, 1-naphthalenesulfonic acid, 4-nitrobenzenesulfonic acid, citric acid, benzoic acid, and hydroxybenzoic acid.

As the basic compound, an amine compound or an ammonium hydroxide compound may be used, and as the compound that generates a base by heat, urea may be used.

Examples of the amine compound include tertiary amines such as triethanolamine, tributanolamine, trimethylamine, triethylamine, tri-n-propylamine, triisopropylamine, tri-n-butylamine, tri-tert-butylamine, tri-n-octylamine, triisopropanolamine, phenyldiethanolamine, stearyldiethanolamine, and diazabicyclooctane, and aromatic amines such as pyridine and 4-dimethylaminopyridine. In addition, examples of the amine compound include primary amines such as benzylamine and n-butylamine, and secondary amines such as diethylamine and di-n-butylamine.

Examples of the ammonium hydroxide compound include tetramethylammonium hydroxide, tetraethylammonium hydroxide, tetrapropylammonium hydroxide, tetrabutylammonium hydroxide, benzyltrimethylammonium hydroxide, benzyltriethylammonium hydroxide, cetyltrimethylammonium hydroxide, phenyltrimethylammonium hydroxide, and phenyltriethylammonium hydroxide.

As the acid generator, both a thermal acid generator and a photoacid generator may be used.

Examples of the thermal acid generator include sulfonic acid compounds such as p-toluenesulfonic acid, trifluoromethanesulfonic acid, pyridinium p-toluenesulfonate (pyridinium p-toluenesulfonic acid), pyridinium p-hydroxybenzenesulfonic acid (p-phenolsulfonic acid pyridinium salt), pyridinium-trifluoromethanesulfonic acid, salicylic acid, camphorsulfonic acid, 5-sulfosalicylic acid, 4-chlorobenzenesulfonic acid, 4-hydroxybenzenesulfonic acid, benzenedisulfonic acid, 1-naphthalenesulfonic acid, citric acid, benzoic acid, and hydroxybenzoic acid, and carboxylic acid compounds.

Examples of the commercially available product include K-PURE [registered trademark] CXC-1612, K-PURE CXC-1614, K-PURE TAG-2172, K-PURE TAG-2179, K-PURE TAG-2678, and K-PURE TAG2689 (manufactured by King Industries, Inc.) and SI-45, SI-60, SI-80, SI-100, SI-110, and SI-150 (manufactured by SANSHIN CHEMICAL INDUSTRY CO., LTD.).

Examples of the photoacid generator include a sulfonium salt, an iodonium salt, sulfonyl diazomethane, N-sulfonyloxyimide, a benzoinsulfonate photoacid generator, a pyrogallol trisulfonate photoacid generator, a sulfone photoacid generator, a glyoxime derivative photoacid generator, an oxime-O-sulfonate acid generator, and a bisoxime sulfonate acid generator. Examples thereof include bis(4-tert-butylphenyl)iodonium trifluoromethanesulfonate, triphenylsulfonium trifluoromethanesulfonate, phenyl-bis(trichloromethyl)-s-triazine, benzoin tosylate, and N-hydroxysuccinimide trifluoromethanesulfonate.

Examples of the thermal base generator include carbamates such as 1-methyl-1-(4-biphenylyl)ethyl carbamate and 2-cyano-1,1-dimethylethyl carbamate; ureas such as urea and N,N-dimethyl-N'-methylurea; guanidines such as guanidine trichloroacetate, guanidine phenyl sulfonyl acetate, and guanidine phenylpropiolate; dihydropyridines such as 1,4-dihydronicotinamide; dimethylpiperidines such as N-(isopropoxycarbonyl)-2,6-dimethylpiperidine, N-(tert-butoxycarbonyl)-2,6-dimethylpiperidine, and N-(benzyloxycarbonyl)-2,6-dimethylpiperidine; quaternized ammonium salts such as tetramethylammonium phenyl sulfonyl acetate and tetramethylammonium phenylpropiolate; and dicyandiamide. In addition, examples thereof include U-CAT (registered trademark) SA810, SA831, SA841, and SA851 [manufactured by San-Apro Ltd.], which are salts of 1,8-diazabicyclo[5.4.0]undec-7-ene (DBU).

Examples of the photobase generator include an alkylamine-based photobase generator such as 9-anthrylmethyl=N,N-diethyl carbamate; a cycloalkylamine-based photobase generator such as 9-anthryl=N,N-dicyclohexyl carbamate, 1-(9,10-anthraquinone-2-yl)ethyl=N,N-dicyclohexyl carbamate, dicyclohexylammonium=2-(3-benzoylphenyl)propionate, 9-anthryl=N-cyclohexylcarbamate, 1-(9,10-anthraquinon-2-yl)ethyl=N-cyclohexyl carbamate, cyclohexylammonium=2-(3-benzoylphenyl) propionate, or (E)-N-cyclohexyl-3-(2-hydroxyphenyl)acrylamide; a piperidine-based photobase generator such as 9-anthrylmethyl=piperidine-1-carboxylate, (E)-1-piperidino-3-(2-hydroxyphenyl)-2-propen-1-one, or (2-nitrophenyl)methyl=4-hydroxypiperidine-1-carboxylate, (2-nitrophenyl)methyl=4-(methacryloyloxy)piperidine-1-carboxylate; a guanidine-based photobase generator such as guanidinium=2-(3-benzoylphenyl)propionate, 1,2-diisopropyl-3-(bis(dimethylamino)methylene)guanidinium=2-(3-benzoylphenyl)propionate, 1,2-dicyclohexyl-4,4,5,5-tetramethylbiguanidium=n-butyltriphenylborate, or 1,5,7-triazabicyclo[4.4.0]dec-5-enium=2-(9-oxoxanthene-2-yl)propionate; and an imidazole-based photobase generator such as 1-(9,10-anthraquinone-2-yl)ethyl=imidazole-1-carboxylate.

The above components may be used each alone or in combination of two or more thereof, and in this case, the components are usually used in a blending amount of 10% by mass or less and preferably 3% by mass or less in a solid content of the protective film-forming composition of the present application.

A method for preparing a protective film composition of the present invention is not particularly limited. That is, a polymer or compound having a crosslinkable group, a solvent, and other components may be mixed in an appropriate ratio and in an appropriate order to form a uniform solution. The thus-prepared protective film-forming composition in a solution state is preferably used after filtration using a filter or the like having a pore size of about 0.2 µm.

As mentioned above, in order to produce a protective film having a film thickness of about 300 nm by a rotary coating method, the protective film-forming composition preferably has a viscosity of about 100 cps or less at 25°C. Note that, in the present invention, the viscosity is a value measured by an E-type viscometer.

As the properties of the protective film covering the edge of the substrate (wafer) for manufacturing a semiconductor, in addition to the above-mentioned function of preventing metal contamination, it is desirable to satisfy dry etching resistance, phosphoric acid resistance, tetramethylammonium hydroxide (TMAH) resistance, HF removability, scratch resistance, excellent embeddability in a stepped substrate, a low sublimation amount, affinity to a hydrophobic substrate, leaving no crater foreign substance or the like on the side surface of the wafer, an excellent edge shape, a function of suppressing inner humps (a phenomenon in which a film forming composition remains in a bump shape immediately below an injection hole of a nozzle), and the like.

In addition, the protective film-forming composition of the present invention is preferably photosensitive. For example, the protective film-forming composition is a negative solvent developing type. In a case of a protective film-forming composition having photosensitivity, the photosensitive protective film-forming composition (negative type) is applied to the front surface edge, and optionally the bevel portion and/or back surface edge, of a substrate, and then a portion where a film is to be cured is exposed and developed, such that the bevel portion can be accurately covered with the protective film. Due to the photosensitivity, it is possible to easily control the film thickness of the protective film on the edge face of the wafer, which is advantageous in that the inner humps may be removed, the edge shape may be improved, and a deviation of the center position at the time of rotary coating may be corrected.

The protective film-forming composition of the present invention may be a composition containing a solvent (F) and a compound (E) having at least one partial structure, the partial structure (I) being selected from partial structures represented in the following Formulas (1-1) to (1-7) disclosed in WO 2018/190380 A: 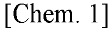 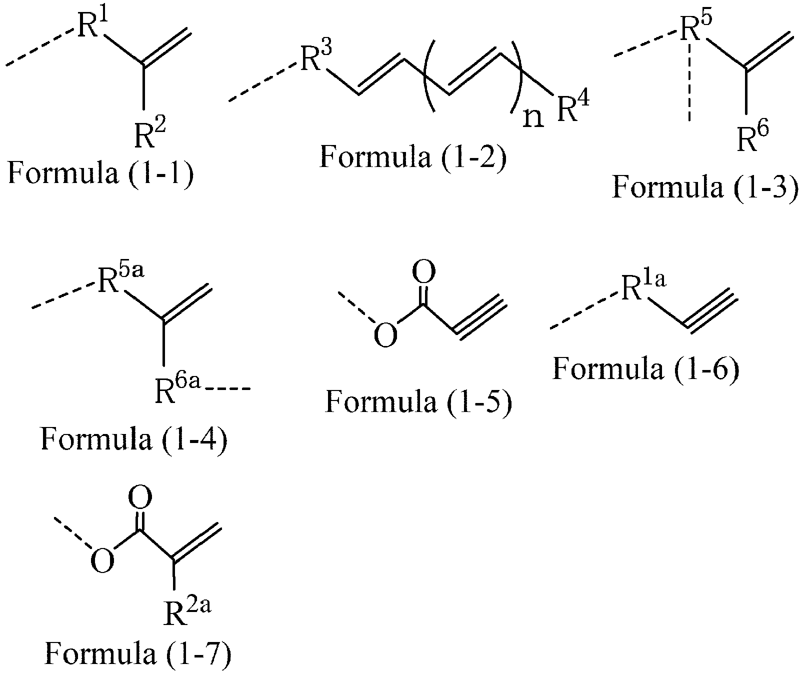
(in the formula, R¹, R^{1a}, R³, R^{5a}, and R^{6a} each independently represent an alkylene group having 1 to 10 carbon atoms, an arylene group having 6 to 40 carbon atoms (the alkylene group and the arylene group may be optionally substituted with one or two or more amide groups or amino groups), an oxygen atom, a carbonyl group, a sulfur atom, -C(O)-NR^{a}-, -NR^{b}-, or a divalent group consisting of a combination thereof,
R^{5'}s each independently represent a nitrogen atom, or a trivalent group consisting of a combination of a nitrogen atom and at least one group selected from the group consisting of an alkylene group having 1 to 10 carbon atoms, an arylene group having 6 to 40 carbon atoms (the alkylene group and the arylene group may be optionally substituted with one or two or more amide groups or amino groups), an oxygen atom, a carbonyl group, a sulfur atom, -C(O)-NR^{a}-, and -NR^{b}-,
R², R^{2a}, R⁴, and R⁶ each independently represent a hydrogen atom, an alkyl group having 1 to 10 carbon atoms, or a monovalent group consisting of a combination of a hydrogen atom and at least one group selected from the group consisting of an alkylene group having 1 to 10 carbon atoms, an oxygen atom, a carbonyl group, a sulfur atom, -C(O)-NR^{a}-, and -NR^{b}-,
R^{a} represents a hydrogen atom or an alkyl group having 1 to 10 carbon atoms,
R^{b} represents a hydrogen atom, an alkyl group having 1 to 10 carbon atoms, or an alkylcarbonyl group having 1 to 10 carbon atoms,
n represents the number of repeating units of 1 to 10, and
a dotted line represents a chemical bond to an adjacent atom).

The entire disclosure of WO 2018/190380 A is incorporated herein by reference.

The protective film-forming composition of the present invention may contain a polysiloxane. The polysiloxane may be a modified polysiloxane in which a part of silanol groups is modified, for example, a modified polysiloxane product in which a part of silanol groups is alcohol-modified or acetal-protected.

In addition, the polysiloxane may be, as an example, a hydrolysis condensate of hydrolyzable silanes, or may be a modified product in which at least a part of silanol groups of the hydrolysis condensate is alcohol-modified or acetal-protected (hereinafter, may be referred to as a "modified product of a hydrolysis condensate"). The hydrolyzable silane related to the hydrolysis condensate may include one or two or more hydrolyzable silanes.

The polysiloxane may have a structure having any of a cage type, ladder type, linear type, and branched type main chain. Further, commercially available polysiloxanes may be used.

Note that, in the present invention, the "hydrolysis condensate" of the hydrolyzable silane, i.e., the product of hydrolysis condensation, includes a polyorganosiloxane polymer that is a condensate of complete condensation, as well as a polyorganosiloxane polymer that is a partial hydrolysis condensate of incomplete condensation. Such a partial hydrolysis condensate is also a polymer obtained by hydrolysis and condensation of a hydrolyzable silane similarly to a condensate of completer condensation, but it is partially hydrolyzed and condensed, and therefore, maintains some Si-OH groups.

Examples of the polysiloxane of the present invention include a hydrolysis condensate of hydrolyzable silanes containing at least one hydrolyzable silane represented by the following Formula (1) or a modified product thereof.
«Formula (1)»
[Chem. 2]

R¹ₐSi(R²)₄₋ₐ (1)

In Formula (1), R¹ is a group bonded to a silicon atom, and independently represents an optionally substituted alkyl group, an optionally substituted aryl group, an optionally substituted aralkyl group, an optionally substituted halogenated alkyl group, an optionally substituted halogenated aryl group, an optionally substituted halogenated aralkyl group, an optionally substituted alkoxyalkyl group, an optionally substituted alkoxyaryl group, an optionally substituted alkoxyaralkyl group, or an optionally substituted alkenyl group, or represents an organic group having an epoxy group, an organic group having an acryloyl group, an organic group having a methacryloyl group, an organic group having a mercapto group, an organic group having an amino group, an organic group having an alkoxy group, an organic group having a sulfonyl group, or an organic group having a cyano group, or a combination of two or more thereof.

In addition, R² is a group or atom bonded to a silicon atom, and independently represents an alkoxy group, an aralkyloxy group, an acyloxy group, or a halogen atom.

a represents an integer of 0 to 3.

Specific examples of each group and atom in R¹ and suitable carbon number thereof in Formula (1) include the group and carbon number mentioned above for R³ in Formulas (A-1) and (A-2).

Specific examples of each group and atom in R² and suitable carbon number thereof in Formula (1) include the group and atom and carbon number mentioned above for X in Formulas (A-1) and (A-2).

### «<Specific examples of hydrolyzable silane represented by Formula (1)»>

Specific examples of the hydrolyzable silane represented by Formula (1) include, but are not limited to, tetramethoxysilane, tetrachlorosilane, tetraacetoxysilane, tetraethoxysilane, tetra-n-propoxysilane, tetra-i-propoxysilane, tetra-n-butoxysilane, methyltrimethoxysilane, methyltrichlorosilane, methyltriacetoxysilane, methyltriethoxysilane, methyltripropoxysilane, methyltributoxysilane, methyltriamyloxysilane, methyltriphenoxysilane, methyltribenzyloxysilane, methyltriphenethyloxysilane, glycidoxy methyltrimethoxysilane, glycidoxy methyltriethoxysilane, α-glycidoxy ethyltrimethoxysilane, α-glycidoxy ethyltriethoxysilane, β-glycidoxy ethyltrimethoxysilane, β-glycidoxy ethyltriethoxysilane, α-glycidoxy propyltrimethoxysilane, α-glycidoxy propyltriethoxysilane, β-glycidoxy propyltrimethoxysilane, β-glycidoxy propyltriethoxysilane, γ-glycidoxy propyltrimethoxysilane, γ-glycidoxy propyltriethoxysilane, γ-glycidoxy propyltripropoxysilane, γ-glycidoxy propyltributoxysilane, γ-glycidoxy propyltriphenoxysilane, α-glycidoxy butyltrimethoxysilane, α-glycidoxy butyltriethoxysilane, β-glycidoxy butyltriethoxysilane, γ-glycidoxy butyltrimethoxysilane, γ-glycidoxy butyltriethoxysilane, δ-glycidoxy butyltrimethoxysilane, δ-glycidoxy butyltriethoxysilane, (3,4-epoxycyclohexyl)methyltrimethoxysilane, (3,4-epoxycyclohexyl)methyltriethoxysilane, β-(3,4-epoxycyclohexyl)ethyltrimethoxysilane, β-(3,4-epoxycyclohexyl)ethyltriethoxysilane, β-(3,4-epoxycyclohexyl)ethyltripropoxysilane, β-(3,4-epoxycyclohexyl)ethyltributoxysilane, β-(3,4-epoxycyclohexyl)ethyltriphenoxysilane, γ-(3,4-epoxycyclohexyl)propyltrimethoxysilane, γ-(3,4-epoxycyclohexyl)propyltriethoxysilane, 6-(3,4-epoxycyclohexyl)butyltrimethoxysilane, δ-(3,4-epoxycyclohexyl)butyltriethoxysilane, glycidoxy methylmethyldimethoxysilane, glycidoxy methylmethyldiethoxysilane, α-glycidoxy ethylmethyldimethoxysilane, α-glycidoxy ethylmethyldiethoxysilane, β-glycidoxy ethylmethyldimethoxysilane, β-glycidoxy ethylethyldimethoxysilane, α-glycidoxy propylmethyldimethoxysilane, α-glycidoxy propylmethyldiethoxysilane, β-glycidoxy propylmethyldimethoxysilane, β-glycidoxy propylethyldimethoxysilane, γ-glycidoxy propylmethyldimethoxysilane, γ-glycidoxy propylmethyldiethoxysilane, γ-glycidoxy propylmethyldipropoxysilane, γ-glycidoxy propylmethyldibutoxysilane, γ-glycidoxy propylmethyldiphenoxysilane, γ-glycidoxy propylethyldimethoxysilane, γ-glycidoxy propylethyldiethoxysilane, γ-glycidoxy propylvinyldimethoxysilane, γ-glycidoxy propylvinyldiethoxysilane, ethyltrimethoxysilane, ethyltriethoxysilane, vinyltrimethoxysilane, vinyltriethoxysilane, vinyltrichlorosilane, vinyltriacetoxysilane, methylvinyldimethoxysilane, methylvinyldiethoxysilane, methylvinyldichlorosilane, methylvinyldiacetoxysilane, dimethylvinylmethoxysilane, dimethylvinylethoxysilane, dimethylvinylchlorosilane, dimethylvinylacetoxysilane, divinyldimethoxysilane, divinyldiethoxysilane, divinyldichlorosilane, divinyldiacetoxysilane, γ-glycidoxy propylvinyldimethoxysilane, γ-glycidoxy propylvinyldiethoxysilane, allyltrimethoxysilane, allyltriethoxysilane, allyltrichlorosilane, allyltriacetoxysilane, allylmethyldimethoxysilane, allylmethyldiethoxysilane, allylmethyldichlorosilane, allylmethyldimethoxysilane acetoxysilane, allyldimethylmethoxysilane, allyldimethylethoxysilane, allyldimethylchlorosilane, allyldimethylacetoxysilane, diallyldimethoxysilane, diallyldiethoxysilane, diallyldichlorosilane, diallyldiacetoxysilane, 3-allylaminopropyltrimethoxysilane, 3-allylaminopropyltriethoxysilane, p-styryltrimethoxysilane, phenyltrimethoxysilane, phenyltriethoxysilane, phenyltrichlorosilane, phenyltriacetoxysilane, phenylmethyldimethoxysilane, phenylmethyldiethoxysilane, phenylmethyldichlorosilane, phenylmethyldiacetoxysilane, phenyldimethylmethoxysilane, phenyldimethylethoxysilane, phenyldimethylchlorosilane, phenyldimethylacetoxysilane, diphenylmethylmethoxysilane, diphenylmethylethoxysilane, diphenylmethylchlorosilane, diphenylmethylacetoxysilane, diphenyldimethoxysilane, diphenyldiethoxysilane, diphenyldichlorosilane, diphenyldiacetoxysilane, triphenylmethoxysilane, triphenylethoxysilane, triphenylacetoxysilane, triphenylchlorosilane, 3-phenylaminopropyltrimethoxysilane, 3-phenylaminopropyltriethoxysilane, dimethoxymethyl-3-(3-phenoxypropylthiopropyl)silane, triethoxy((2-methoxy-4-(methoxymethyl)phenoxy)methyl)silane, benzyltrimethoxysilane, benzyltriethoxysilane, benzylmethyldimethoxysilane, benzylmethyldiethoxysilane, benzyldimethylmethoxysilane, benzyldimethylethoxysilane, benzyldimethylchlorosilane, phenethyltrimethoxysilane, phenethyltriethoxysilane, phenethyltrichlorosilane, phenethyltriacetoxysilane, phenethylmethyldimethoxysilane, phenethylmethyldiethoxysilane, phenethylmethyldichlorosilane, phenethylmethyldiacetoxysilane, methoxyphenyltrimethoxysilane, methoxyphenyltriethoxysilane, methoxyphenyltriacetoxysilane, methoxyphenyltrichlorosilane, methoxybenzyltrimethoxysilane, methoxybenzyltriethoxysilane, methoxybenzyltriacetoxysilane, methoxybenzyltrichlorosilane, methoxyphenethyltrimethoxysilane, methoxyphenethyltriethoxysilane, methoxyphenethyltriacetoxysilane, methoxyphenethyltrichlorosilane, ethoxyphenyltrimethoxy silane, ethoxyphenyltriethoxysilane, ethoxyphenyltriacetoxysilane, ethoxyphenyltrichlorosilane, ethoxybenzyltrimethoxysilane, ethoxybenzy ltri ethoxysilane, ethoxybenzyltiiacetoxysilane, ethoxybenzyltrichlorosilane, i-propoxyphenyltrimethoxysilane, i-propoxyphenyltriethoxysilane, i-propoxyphenyltriacetoxy silane, i-propoxyphenyltrichlorosilane, i-propoxybenzyltrimethoxysilane, i-propoxybenzyltriethoxysilane, i -propoxybenzyltriacetoxysilane, i-propoxybenzyltrichlorosilane, t-butoxyphenyltrimethoxysilane, t-butoxyphenyltriethoxysilane, t-butoxyphenyltriacetoxysilane, t-butoxyphenyltrichlorosilane, t-butoxybenzyl trimethoxysilane, t-butoxybenzyltriethoxysilane, t-butoxybenzyltriacetoxysilane, t-butoxybenzyltrichlorosilane, methoxynaphthyltrimethoxysilane, methoxynaphthyltriethoxysilane, methoxynaphthyltriacetoxysilane, methoxynaphthyltrichlorosilane, ethoxynaphthyltrimethoxysilane, ethoxynaphthyltriethoxysilane, ethoxynaphthyltriacetoxysilane, ethoxynaphthyltrichlorosilane, γ-chloropropyltrimethoxysilane, γ-chloropropyltriethoxysilane, γ-chloropropyltriacetoxysilane, 3,3,3-trifluoropropyltrimethoxysilane, γ-methacryloxypropyltrimethoxysilane, γ-mercaptopropyltrimethoxysilane, γ-mercaptopropyltriethoxysilane, β-cyanoethyltriethoxysilane, thiocyanatepropyltriethoxysilane, chloromethyltrimethoxysilane, chloromethyltriethoxysilane, triethoxysilylpropyl diallyl isocyanurate, bicyclo[2,2,1]heptenyltriethoxysilane, benzenesulfonylpropyltriethoxysilane, benzenesulfonamidopropyltriethoxysilane, dimethylaminopropyltrimethoxysilane, dimethyldimethoxysilane, phenylmethyldimethoxysilane, dimethyldiethoxysilane, phenylmethyldiethoxysilane, γ-chloropropylmethyldimethoxysilane, γ-chloropropylmethyldiethoxysilane, dimethyldiacetoxysilane, γ-methacryloxypropylmethyldimethoxysilane, γ-methacryloxypropylmethyldiethoxysilane, γ-mercaptopropylmethyldimethoxysilane, γ-mercaptomethyldiethoxysilane, methylvinyldimethoxysilane, and methylvinyldiethoxysilane.

The protective film-forming composition of the present invention may contain:
(A) a polyfunctional epoxy (meth)acrylate compound;
(B) a polyfunctional thiol compound; and
(C) a radical polymerization initiator,
which are described in JP 2016-003160 A.

A molecular weight of the component (A) may be within the range of 300 to 20,000.

The component (A) may be a bisphenol-type polyfunctional epoxy (meth)acrylate compound.

The component (B) may be liquid at 25°C.

Further, (D) a polymerization inhibitor may be contained.

A viscosity at 25°C may be within the range of 2,000 to 100,000 mPa·s.

The entire disclosure of JP 2016-003160 A is incorporated herein by reference.

The protective film-forming composition of the present invention may be a film-forming composition containing a photopolymerizable substance and a photopolymerization initiator disclosed in WO 2009/104643 A.

The photopolymerizable substance may be a compound having at least one cationically polymerizable reactive group, and the cationic polymerization initiator may be a photocationic polymerization initiator.

The photopolymerizable substance may be a compound having at least one radical polymerizable reactive group, and the photopolymerization initiator may be a photoradical polymerization initiator.

The photopolymerizable compound may be a sugar compound.

The sugar compound may be a monosaccharide or disaccharide compound.

The sugar compound may be Formula (10): 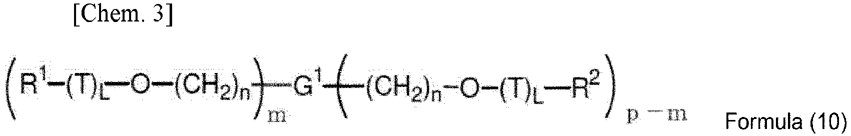 (wherein G¹ represents a sugar skeleton, T represents a divalent linking group, R¹ represents a vinyl group or a glycidyl group, and R² represents a hydrogen atom or a hydroxy group, n and L each represent an integer of 0 or 1, and p is an integer and a total number of hydroxy groups of the sugar, and m is an integer satisfying 1 ≤ m ≤ (p-m)).

The photopolymerizable compound may be an alicyclic epoxy compound or an alicyclic oxetane compound.

The alicyclic epoxy compound may be a cycloalkylene oxide derivative.

The alicyclic epoxy compound may be Formula (2) or Formula (3): 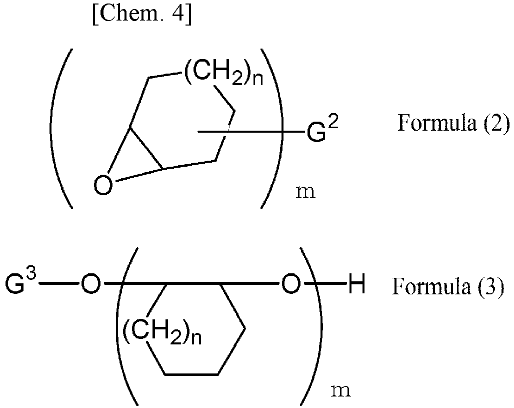 (wherein G² represents an alkylene group, a carbonyloxy group, a heterocyclic ring, an aromatic ring, or a monovalent to pentavalent linking group having a combination thereof, G³ represents an alkyl group, an alkylcarbonyl group, a heterocyclic ring, an aromatic ring, or an organic group having a combination thereof, and n and m each represent an integer of 1 to 5).

The entire disclosure of WO 2009/104643 A is incorporated herein by reference.

### Examples

Hereinafter, the present invention will be described in more detail with reference to Synthesis Examples and Examples, but the present invention is not limited to only the following Examples. Note that, in Examples, apparatuses and conditions used for analyzing physical properties of samples are as follows.

### (Measurement of molecular weight)

The molecular weight of the polysiloxane used in the present invention is a molecular weight obtained in terms of polystyrene by GPC analysis.

Measurement of GPC can be performed using, for example, a GPC apparatus (trade name: HLC-8220 GPC, manufactured by Tosoh Corporation), a GPC column (TSKgel Super-MultiporeHZ-N (2 columns)) under conditions of a column temperature of 40°C, an eluent (elution solvent) of tetrahydrofuran, a flow amount (flow rate) of 0.35 mL/min, and polystyrene (manufactured by Sigma-Aldrich) as a standard sample.

### [1] Synthesis of polymer

### <Synthesis Example 1>

20.8 g of tetraethoxysilane, 24.8 g of 3-(trimethoxysilyl)propyl methacrylate, 0.4 g of 2,6-di-t-butyl-4-methylphenol, and 19.6 g of propylene glycol monomethyl ether were charged in a 300 ml flask, and 25.2 g of a 0.2 M aqueous nitric acid solution was added dropwise to the resulting mixed solution while stirring the mixture with a magnetic stirrer. After the dropwise addition, the flask was transferred to an oil bath adjusted to 80°C and refluxed for 20 hours. Thereafter, methanol, ethanol, and water as reaction by-products were distilled off under reduced pressure and concentrated to obtain a hydrolysis condensate (polymer) solution.

Further, propylene glycol monomethyl ether was added thereto, so as to adjust the concentration to 20 mass percent in terms of solid residue at 150°C, while taking propylene glycol monomethyl ether as a solvent ratio of 100%. The resulting solution was filtered with a nylon filter (pore size: 0.1 µm). The yielded polymer contained a structure represented by the following Formula (YY), and had a weight average molecular weight Mw of 3,300 in terms of polystyrene by GPC.

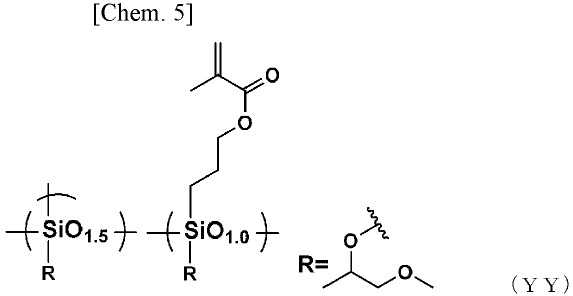

### <Synthesis Example 2>

101.11 g of propylene glycol monomethyl ether acetate was added to 30.00 g of an epoxy group-containing novolac resin (product name: EPPN-201, epoxy value: 192 g/eq., manufactured by Nippon Kayaku Co., Ltd.), 11.26 g of acrylic acid, 1.99 g of tetrabutylphosphonium bromide, and 0.09 g of hydroquinone, and the mixture was heated and stirred at 100°C for 18 hours under a nitrogen atmosphere. 43 g of a cation exchange resin (trade name: DOWEX [registered trademark] 550A, MUROMACHI CHEMICALS INC.) and 43 g of an anion exchange resin (trade name: AMBERLITE [registered trademark] 15JWET, ORGANO CORPORATION) were added to the resulting solution, and an ion exchange treatment was performed at room temperature for 4 hours. Separating the ion exchange resins gave a compound solution. The resulting compound corresponded to Formula (XX), and had a weight average molecular weight Mw in terms of polystyrene determined by GPC of 6,900.

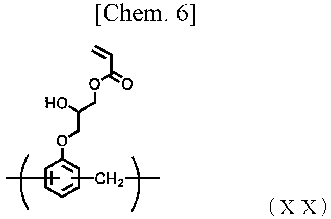

### <Synthesis Example 3>

20.8 g of tetraethoxysilane, 24.21 g of (3-mercaptopropyl)trimethoxysilane, 3.18 g of vinyltrimethoxysilane, and 18.8 g of propylene glycol monomethyl ether were charged in a 100 ml flask, and 14.2 g of a 0.2 M aqueous nitric acid solution was added dropwise to the resulting mixed solution, while stirring the mixture with a magnetic stirrer. After the dropwise addition, the flask was transferred to an oil bath adjusted to 80°C and refluxed for 20 hours. Thereafter, methanol, ethanol, and water as reaction by-products were distilled off under reduced pressure and concentrated to obtain a hydrolysis condensate (polymer) solution.

Further, propylene glycol monomethyl ether was added thereto, so as to adjust the concentration to 20 mass percent in terms of solid residue at 150°C, while taking propylene glycol monomethyl ether as a solvent ratio of 100%. The resulting solution was filtered with a nylon filter (pore size: 0.1 µm). The yielded polymer contained a structure represented by the following Formula (ZZ), and had a weight average molecular weight Mw of 3,400 in terms of polystyrene by GPC.

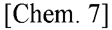

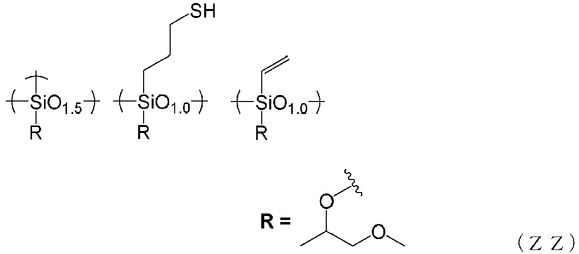

### [2] Preparation of protective film-forming composition

### <Preparation Example 1>

0.48 g of Irgacure Oxe01 (manufactured by BASF Japan Ltd.) as a photopolymerization initiator and 0.01 g of MEGAFACE R-30 (trade name, manufactured by DIC Corporation) as a surfactant were mixed with 9.5 g of the polysiloxane (polymer) obtained in Synthesis Example 1, and the mixture was dissolved in 51.9 g of propylene glycol monomethyl ether to obtain a solution of a protective film-forming composition.

### <Preparation Example 2>

To 11.72 g of the resin solution (solid content: 23.73 % by mass) obtained in Synthesis Example 2 were added 0.28 g of Irgacure Oxe01 (manufactured by BASF Japan Ltd.) as a photopolymerization initiator, 0.008 g of MEGAFACE R-30 (manufactured by DIC Corporation) as a surfactant, 0.042 g of Irganox 3114 (manufactured by BASF Japan Ltd.) as an antioxidant, 0.042 of KBM-5103 (manufactured by Shin-Etsu Chemical Co., Ltd.) as an adhesion improver, and 17.91 g of propylene glycol monomethyl ether acetate, to obtain a solution of a protective film-forming composition.

### <Preparation Example 3>

0.12 g of Irgacure Oxe01 (manufactured by BASF Japan Ltd.) as a photopolymerization initiator and 0.005 g of MEGAFACE R-30 (trade name, manufactured by DIC Corporation) as a surfactant were mixed with 24.4 g of the polysiloxane (polymer) obtained in Synthesis Example 1, and the mixture was dissolved in 23.3 g of propylene glycol monomethyl ether and 2.3 g of ultrapure water to obtain a solution of a protective film-forming composition.

### [3] Evaluation of curability after exposure

As Examples 1 and 2, each of the protective film-forming compositions prepared in Preparation Examples 1 and 2 was spin-coated on a silicon wafer, and then the wafer edge was exposed to a light from a mercury lamp at an exposure amount of 36 mJ/cm² (wavelength of 254 nm) using a wafer edge exposure module (WEE) of a coater/developer LithiusPro manufactured by Tokyo Electron Limited. After the exposure, development was performed for 30 seconds using OK73 thinner (manufactured by TOKYO OHKA KOGYO CO., LTD.) as a developer, and a pattern was formed on the wafer edge.

Using an optical interference film thickness measuring apparatus (VM-3210) manufactured by SCREEN Holdings Co., Ltd., the coated film thickness and the film thickness of the pattern left behind the development were measured, from which a residual film ratio after development (the film thickness of the pattern left behind the development/the coated film thickness) was calculated. The results are shown in Table X.

### [Table 1]

**Table 1**

| | Protective film-forming composition | Coated film thickness (nm) | Film thickness of the pattern left behind the development (nm) | Residual film ratio (%) |
|---|---|---|---|---|
| Example 1 | Preparation Example 1 | 300 | 234 | 78 |
| Example 2 | Preparation Example 2 | 300 | 218 | 73 |
| Example 3 | Preparation Example 3 | 300 | 276 | 92 |

### Industrial Applicability

According to the present invention, it is possible to provide a protective film capable of completely covering an edge of a substrate (wafer) for manufacturing a semiconductor by a simple method by application, a protective film-forming composition for forming the protective film, a wafer for manufacturing a semiconductor produced using the protective film, and methods for manufacturing the wafer for manufacturing a semiconductor and a semiconductor device in manufacturing a semiconductor device.

## Claims

1. A wafer edge protective film-forming composition for manufacturing a semiconductor, comprising a polymer or compound having a crosslinkable group, and a solvent.

2. The protective film-forming composition according to claim 1, wherein the crosslinkable group is selected from the group consisting of an epoxy group, a (meth)acrylic group, a vinyl group, a carboxylic acid group, a thiol group, a silanol group, a cinnamoyl group, and a hydroxy group.

3. The protective film-forming composition according to claim 1, which has a viscosity of 100 cps or less at 25°C.

4. The protective film-forming composition according to claim 1, which is photosensitive.

5. A protective film, which is a cured product of a coating film of the protective film-forming composition according to any one of claims 1 to 4.

6. The protective film according to claim 5, which has a thickness of 1 to 10 µm.

7. The protective film according to claim 5, which is for preventing metal contamination of a wafer edge.

8. The protective film according to claim 5, which has been cured by a light having a wavelength of 170 to 800 nm.

9. A wafer for manufacturing a semiconductor having a protected wafer edge, formed from the protective film-forming composition according to any one of claims 1 to 4 applied to an edge of a wafer precursor.

10. A method for manufacturing a semiconductor device, comprising the steps of:
(A) forming a resist film on a semiconductor substrate;
(B) forming a resist pattern by irradiation of the resist film with a light or electron beam and subsequent development; and
(C) processing the semiconductor substrate by etching,
wherein the method includes a step (X) of forming a protective film of the protective film-forming composition according to any one of claims 1 to 4 on a front surface edge, and optionally on a bevel portion and/or back surface edge, of a wafer for manufacturing a semiconductor.

11. The method for manufacturing a semiconductor device according to claim 10, wherein the method includes the step (X) before the step (A).

12. The method for manufacturing a semiconductor device according to claim 10, wherein the method includes the step (X) between the step (A) and the step (B).

13. The method for manufacturing a semiconductor device according to claim 10, wherein the method includes the step (X) after the step (B) or after the step (C).

14. The method for manufacturing a semiconductor device according to claim 10, wherein the method includes, after the step (X), a step (Y) of removing the resist film formed on the protective film.

15. The method for manufacturing a semiconductor device according to claim 10, wherein the method includes, after the step (X), a step (Z) of removing the protective film.

16. The method for manufacturing a semiconductor device according to claim 14, wherein the method includes, after the step (Y), a step (Z) of removing the protective film.

17. The method for manufacturing a semiconductor device according to claim 10, wherein the resist film contains a metal.

18. The method for manufacturing a semiconductor device according to claim 10, wherein the step (X) includes applying the protective film-forming composition according to claim 4 followed by exposure and development thereof on a predetermined region.

19. The method for manufacturing a semiconductor device according to claim 15, wherein the step (Z) is performed by ashing, or a treatment with hydrofluoric acid, an organic solvent, an alkaline developer or a semiconductor cleaning solution.

20. The method for manufacturing a semiconductor device according to claim 16, wherein the step (Z) is performed by ashing, or a treatment with hydrofluoric acid, an organic solvent, an alkaline developer or a semiconductor cleaning solution.

21. A method for manufacturing a wafer for manufacturing a semiconductor, comprising the step of applying the protective film-forming composition according to any one of claims 1 to 4 to an edge of a wafer precursor to produce a wafer having a protected edge.
